# EUROPEAN PATENT SPECIFICATION

(11) **EP 1 792 288 B1**
(45) Date of publication and mention of the grant of the patent: **28.11.2012**
(21) Application number: 05798683.8
(22) Date of filing: 20.09.2005
(51) Int. Cl.: G01D 9/00, G11C 16/10, G11C 5/14, G11C 14/00

(54) **METHOD OF USING FLASH MEMORY FOR STORING METERING DATA**
VERFAHREN ZUR VERWENDUNG EINES FLASH-SPEICHERS ZUR SPEICHERUNG VON MESSDATEN
PROCEDE D'UTILISATION DE MEMOIRE FLASH POUR LE STOCKAGE DE DONNEES DE MESURE

(30) Priority: 24.09.2004 US 949603
(43) Date of publication of application: 06.06.2007
(60) Divisional application: 11154116.5
(73) Proprietor: Itron, Inc., Liberty Lake, WA 99019 (US)
(72) Inventor: SEAL, Brian, Westminster, South Carolina 29693 (US); NORROD, Eric, Westminster, South Carolina 29693 (US); SIMMONS, Stephen, Melbourne, Florida 32940 (US)
(74) Representative: Schlief, Thomas P.
(86) International application number: PCT/US2005/033606
(87) International publication number: WO 2006/036650

(56) References cited:
- EP-A- 1 031 929
- US-A- 4 327 410
- US-A- 4 564 922
- US-A- 4 602 341
- US-A1- 2003 201 904
- US-B1- 6 219 656
- US-B1- 6 285 955
- US-B1- 6 405 279
- US-B2- 6 510 316

## Description

### PRIORITY CLAIM

This application is a continuation-in-part of previously filed U.S. Patent Application with the same title and inventors as present, assigned USSN 10/131,605, filed April 24, 2002, and published as US 2003/0201 904, October 30, 2003.

### BACKGROUND OF THE INVENTION

The present subject matter generally relates to particular flash memory storage applications. More particularly, the present subject matter relates to a method of using flash memory for the storage of metering data. Still further, the present subject matter relates to a method for using flash memory in conjunction with an associated memory for the storage and manipulation of metering data and maintaining such data despite a loss of power.

Conventional memory systems are well known. Large amounts of data are commonly stored using rotating storage media such as magnetic disk drives. Such systems are slow to recover and store data. Additionally, such systems require large amounts of power and are relatively heavy. It has been appreciated in many conventional memory systems that some data needs to be stored in non-volatile memory, which by definition maintains data stored therein despite lack of power to the memory. Aspects of such non-volatile data storage are addressed in accordance with the present subject matter.

Various constraints pertaining to the amount of data that can be erased at a given time from certain existing flash memory systems have limited their typical use to storing programs and constants that are erased and then rewritten in their entirety. In general, such systems are not used to store data because data is typically not changed in its entirety. Instead, data has typically been stored in alternative memory structures, such as EPROMS, EEPROMS, and a variety of RAM structures, which allow the alteration of only a portion of the stored information. Such memory structures, however, are less cost effective than flash memory systems and in the case of certain types of RAM, namely battery-backed RAM, there are additional lifetime costs associated with the maintenance of the battery.

Early flash memory systems consisted of a single storage block for storing information. Such individual storage locations cannot be rewritten to until such time as they are erased. The erasure of stored information in such memory, however, cannot occur on a partial basis. Instead, erasure of such information must be complete at which point all previously stored information is lost. The number of times flash memory can be erased and then rewritten is also limited over the lifetime of flash memory, and has also thus been a concern for certain applications.

Conventional flash memory systems have been developed such that they are more useful in storing data. Such flash memory has been segmented into large numbers of smaller storage locations. These most recent flash memory systems are flexible enough to store data and are ideally suited for use in the storage of metering data. While each of such storage blocks must still be erased in its entirety, such flash memory devices contain enough small storage blocks to satisfactorily maintain stored metering data.

These conventional flash memory systems consume very little power and are relatively fast to operate. New flash memory is also much more cost effective than other non-volatile memory such as EPROM, EEPROM, etc. In addition to being more cost effective, such conventional flash memory systems are currently available in higher density arrays than comparable EEPROM and RAM memory systems. As the demand for the storage of more metering data is made in the utility industry, cost savings realized through the use of more efficient and cheaper memory systems will be significant.

Non-volatile memory systems have been used in the past for various metering applications, but utilization of flash memory has been limited. Some conventional metering systems have utilized non-volatile memory for the storage of constant values and equations for performing calculations that may determine otherwise desired parameters of a meter's performance or the demand therethrough. One example of the use of non-volatile memory structures in metering applications is U.S. Patent No. 5,548,527. Yet another example is found in U.S. Patent No. 4,361,877, which provides for the use of non-volatile memory to store a set of data measurements obtained over time and compiled within an associated memory. Such non-volatile memory is then removed for further processing to obtain the desired data and replaced by a new memory structure.

Utilizing a battery-backed RAM memory to store data, as well as to attempt to preserve such data during power outages to ensure the continuity of the usage data despite the power loss is the aim of U.S. Patent No. 4,335,447.

Other patents referencing the use of various types of memory structures to handle and store utility metering data include U.S. Patent Nos. 4,783,623; 4,792,677; 4,852,030; 5,270,639; 5,311,068; 5,377,114; 5,473,322; 5,918,380; 5,994,892; 6,006,212; and 6,163,276.

While useful for their purposes, none of the above references solves the problems addressed by the presently disclosed technology, namely, the need for a cost-effective, efficient, non-volatile memory structure and associated methodology used to store metering data while not requiring replacement.

It is, therefore, desirable to provide a method for using a more cost-effective memory, such as flash memory, to store metering data. Still further, it is desirable to provide a method of using such flash memory in conjunction.with an additional associated memory structure to reduce the number of times flash memory is written to and erased, thus helping to extend the useable life cycle of the flash memory. Finally, it is desirable to utilize a mutli-segmented flash memory for storing metering data in conjunction with an associated memory structure for use in updates and maintenance of the metering data during periods when measurements are taken.

### BRIEF SUMMARY OF THE INVENTION

The present subject matter recognizes and addresses various of the foregoing limitations and drawbacks, and others, concerning the storage of measured metering data and the maintenance of that data during a loss of power. Therefore, the presently disclosed technology provides a new method of storing metering data into more cost effective non-volatile flash memory structures, while providing specific data transfer algorithms that maximize the potential lifespan of such memory structures.

It is, therefore, a principle object of the disclosed technology to provide a method for using non-volatile flash memory for storing information. More particularly, it is an object of the present subject matter to provide a method for using such memory in conjunction with an associated memory for storing and maintaining data. It is a related object of the present subject matter to provide a specific algorithm for transferring data between flash memory and an associated memory to minimize the number of times the flash memory is written, erased, and/or rewritten thereto, thus helping to prolong the life of the flash memory.

It is a further object of the present subject matter to provide a method of protecting metering data during an unscheduled loss of power or during a regular (i.e., user planned) meter power down. More particularly, it is an object of the present subject matter to provide a method of protecting metering data during a loss of power using a combination of two distinct interacting memory structures.

It is still another object of the presently disclosed technology to provide a method that is cost effective for storing metering data. In such context, it is a further object of the present technology to provide a more flexible and efficient method for the storage of metering data.

Additional objects and advantages of the present subject matter are set forth in, or will be apparent to those of ordinary skill in the art, from the detailed description as follows. Also, it should be further appreciated that modifications and variations to the specifically illustrated and discussed steps, features, and materials, or devices hereof may be practiced in various embodiments and uses of the disclosed technology without departing from the scope thereof, by virtue of present reference thereto. Such variations may include, but are not limited to, substitutions of equivalent steps, elements, features, and materials for those shown or discussed, and the functional or positional reversal of various steps, parts, features, or the like.

Still further, it is to be understood that different embodiments, as well as different presently preferred embodiments, of the present subject matter may include various combinations or configurations of presently disclosed steps, features, elements, or their equivalents (including combinations of features or configurations thereof not expressly shown in the figures or stated in the detailed description).

In accordance with one exemplary embodiment of the present subject matter, a method for storing meter data includes an initial step of providing a plurality of memory structures, including at least one associated memory buffer and a non-volatile flash memory structure having a plurality of memory blocks. Meter data representative of one or more parameters associated with a utility product or service may then be obtained and stored in the associated memory buffer. When the associated memory buffer is full, the data is copied to at least one selected block of the flash memory. The memory buffer can then be erased and a flash pointer moved to a next block of flash memory, such that the data storage steps can be subsequently repeated until either the flash memory is full or until the data stored in flash memory begins to repeat its predetermined storage sequence.

A preferred embodiment of the present invention corresponds to a method for storing and altering meter data. Data stored in block (s) of flash memory is copied to an associated memory structure where portions of such data can be updated, and then copied back to the erased location in flash memory from which the data was transferred.

These and other features, aspects and advantages of the present technology will become better understood with reference to the following description and appended claims. The accompanying drawings, which are incorporated in and constitute a part of this specification, illustrate an embodiment of the present subject matter and, together with the description, serve to explain the principles of the technology.

### BRIEF DESCRIPTION OF THE DRAWINGS

A full and enabling disclosure of the present subject matter, including the best mode thereof, directed to one of ordinary skill in the art, is set forth in the specification, which makes reference to the appended figures, in which:
Figure 1 provides a block diagram illustrating aspects of the transfer of data between a given non- volatile memory and an associated memory in accordance with the present subject matter;
Figure 2 is a flow chart diagram of the data preservation methodology for power loss occurrences in accordance with the present subject matter;
Figure 3 is a flow chart diagram of the data storage methodology for newly acquired data in accordance with the present subject matter; and
Figure 4 is a flow chart diagram of a data preservation and storage methodology that provides a data protection scheme during loss of power to the meter in accordance with the present subject matter.

Repeat use of reference characters throughout the present specification and appended drawings is intended to represent the same or analogous features, steps or elements of the disclosed technology.

### DETAILED DESCRIPTION OF THE PREFERRED EMBODIMENTS

Reference will now be made in detail to presently preferred embodiments of the disclosed technology, examples of which are fully represented in the accompanying drawings. Such examples are provided by way of an explanation of the present technology, not limitation thereof. In fact, it will be apparent to those skilled in the art that various modifications and variations can be made in the present subject matter, without departing from the scope thereof. For instance, features or steps illustrated or described as part of one embodiment can be used on another embodiment to yield a further embodiment. Still further, variations in selection of materials and/or characteristics may be practiced, as well as, alteration in some instances of some of the order of method steps to satisfy particular desired user criteria. Thus, it is intended that the present subject matter cover such modifications and variations as come within the scope of the present features and their equivalents.

As disclosed above, the present subject matter is particularly concerned with a method of utilizing flash memory structures for the storage and retention of metering data. In particular, the present subject matter provides a method of using a flash memory structure with an additional associated memory structure in a utility metering environment. Certain embodiments of the disclosed technology are further directed to a method of insuring against data loss in the event of a power outage in, or power down of, the utility meter.

Generally, various metering data, including but not limited to such as load profiles, energy data, time-of-use data, informational data, error/event/history logs, and self-reads are collected and stored for later retrieval either by authorized field personnel or via transmission to a remote location. Such information is often used, for example, to better determine appropriate billing rates both for various time periods during any 24 hour period, as well as, alternative billing rates for residential versus commercial users and for variations in demand from season to season. In some applications, a meter runs continuously while amassing relatively large amounts of data, such as event logs or log profiles. In such an application, the newly amassed data can be initially stored in an associated memory, for example but not limited to a RAM buffer, and then incrementally transferred to a nonvolatile flash memory in accordance with an algorithm (discussed herein) that helps reduce the number of times data is written to the flash memory. In still further metering applications, metered data such as watt-hours (in the case of electricity metering) continuously change. In this type of application, the watt-hour number(s) can be stored in an associated buffer until a regular (i.e., user planned) power down or unscheduled loss of power, when it is written at the last moment to the flash memory provided in conjunction with the associated buffer.

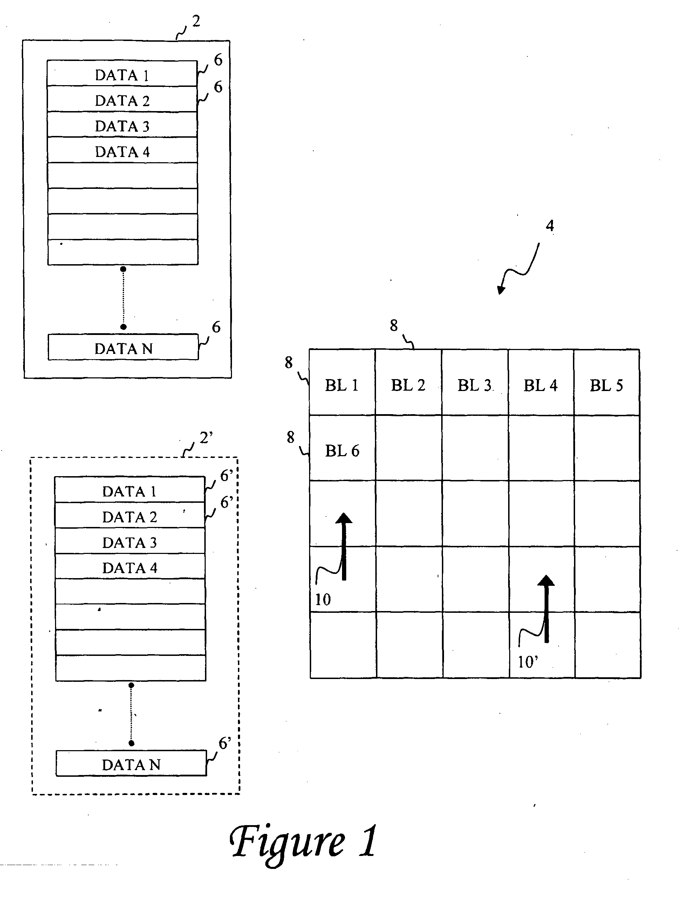

Referring now to Figure 1, a block diagram depicts aspects of an exemplary configuration and corresponding methodology for acquiring meter data and storing such data into nonvolatile flash memory. The exemplary configuration of Figure 1 includes an associated memory 2 configured to operate in conjunction with a nonvolatile flash memory 4. Associated memory 2 is configured to operate as a buffer for acquired metering data, and may correspond to a RAM buffer or to another specific form of memory, such as but not limited to EPROM, EEPROM, Ferro RAM, Shadow RAM, or battery-backed RAM. Associated memory 2 preferably includes a plurality of data blocks 6, which are respectively represented in Figure 1 as DATA 1, DATA 2,..., DATA N, and flash memory 4 preferably includes a plurality of flash memory blocks 8 respectively represented as BL 1, BL 2, BL 3,....

When new data is acquired by a utility meter, it is initially written to a block or blocks of associated memory 2. Subsequently measured new data is sequentially written to the associated memory 2 until the associated buffer 2 is full. The associated memory serves as a buffer, and when the associated memory 2 is full, all the data stored therein is written to a selected empty block or blocks 8 of non-volatile flash memory 4. After the data is written to flash, the associated memory buffer is cleared so that more data can be written to it, and the data transfer process repeats.

A flash pointer 10 is employed in order to determine to which block(s) 8 of flash memory 4 the associated memory buffer 2 is to be written. When the associated memory 2 is written to a block of flash, the memory 2 is cleared and the flash pointer is moved to the next empty block 8 of flash memory, not necessarily in a sequential order. The flash pointer 10 may be incremented to point to sequential blocks of flash or may follow any other predetermined order for filling up the flash blocks. The arrays of flash blocks 8 can either sequence circularly (i.e., newly buffered data is written to the flash block containing the oldest data) or the flash memory 4 can be written to until all the flash blocks 8 are full, at which point data transfer between the associated memory 2 and the flash memory 4 stops. The flash memory 4 can then be cleared when the meter is read, so that more data can be stored therein.

The associated memory buffer 2 is used to reduce the frequency of data writes to flash memory 4. An entire memory buffer of, for example 20 or more load profiles entries is filled up before the block is written to flash memory. An exemplary data storage size for associated memory 2 may be about 2K, which may preferably correspond in some embodiments to the size of each block 8 of flash memory 4. In such instance, if the total storage size of flash memory was 256K and each block 8 corresponds to 2K of storage, then 128 respective block transfers of data from associated memory 2 to flash memory 4 would fill up all the data blocks 8 in flash. In other embodiments of the present technology, flash memory 4 preferably contains at least about thirty-two distinct flash memory blocks 8. These numbers are presented for example only, and it should be appreciated that the associated memory and flash memory could be of any particular size, although the associated memory is generally some fractional size of the flash memory.

It should be appreciated with respect to Figure 1 that many associated memory buffers may be running at the same time, and being respectively copied into the flash memory 4. For example, one associated memory buffer 2 can be dedicated to storing load profile data, while another separate memory buffer 2' is dedicated to storing event logs. Each buffer 2 and 2' can respectively copy into different streams of flash blocks 8 as they respectively fill up. Multiple flash pointers may be employed to determine to where each respective buffer will copy in the flash memory.

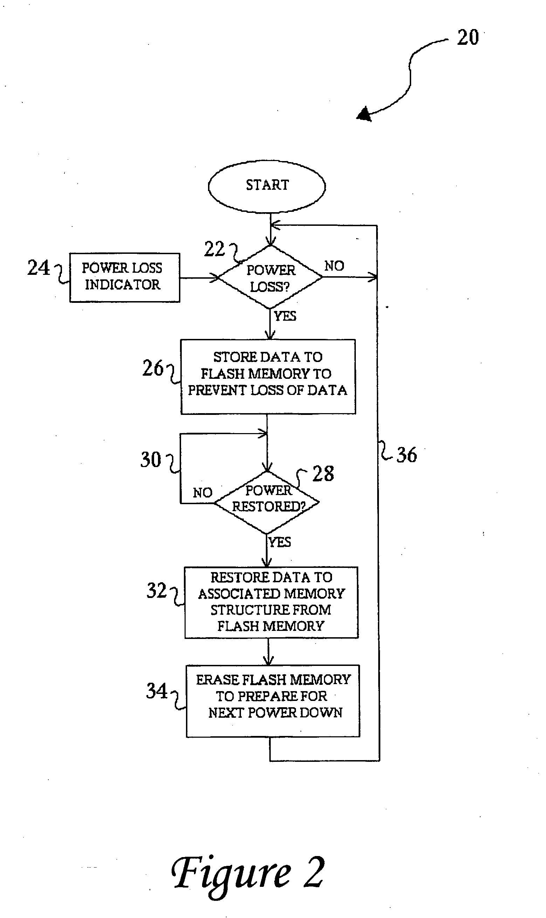

Figure 2, representing an embodiment not reflected in the claims, shows a flow chart diagram 20 in which a protection scheme is provided for measured data during the occurrence of a power failure or a regular meter power down. Metering data is stored in a supplemental memory structure, such as an EPROM, EEPROM, or a Ferro RAM, Shadow RAM, battery-backed RAM or other similar memory structure. Such supplemental memory is associated with a non-volatile flash memory structure, and thus may be hereafter referred to as "associated memory."

Upon the detection of an impending power loss or power down, there is a need to save any previously measured or calculated metering data. In accordance with the present subject matter, there may exist means 22 for detection of a power loss or power down. Power loss detection means 22 may correspond to a variety of particular implementations. For example, power losses could be detected during software instruction or via a specific sensor element or other appropriate circuitry. Details of detecting power loss, which form no particular aspect of the present technology, may be accomplished in any of numerous previously known ways. When such an event is detected at step 24, selected of the presently stored data is rewritten in step 26 into the non-volatile flash memory from the associated memory structure. In certain instances, it is desired to transfer all or selected portions of data stored in the associated memory structure into flash memory at step 26. By definition, the non-volatile flash memory structure will maintain without loss all of the data stored therein despite the lack of power to the memory. In such a manner, all of the previously acquired metering data may be preserved.

Continuing with the exemplary embodiment of the present subject matter illustrated in Figure 2, upon the occurrence of step 26 a meter begins checking at step 28 for a restoration of power to the meter, or for initial provision of power during a typical meter power up. Details of checking for the restoration or initial provision of power, which form no particular aspect of the present technology, may be accomplished in any of numerous previously known ways. If no power is detected at step 28, the power detection methodology loops back at path 30 and continues to check for power restoration until power is detected. Before a meter's typical power up (as opposed to a restoration of inadvertently lost power), this loop back may not be involved. Upon detection in step 28 of the restoration or initial provision of power to the solid-state meter, all the data previously transferred in step 26 is restored to the associated memory structure in step 32. Once the metering information is restored to the associated memory from the flash memory in step 32, the flash memory location is erased in step 34. Step 34 ensures that the flash memory will be prepared to store new information upon a subsequent power failure. After completion of exemplary step 34, the process loops back along path 36 to the beginning of the process 20 where the pertinent technology once again begins checking for the next loss of power.

In such method, the limited use of the non-volatile flash memory structure aids in reducing the continuous writing, erasing and rewriting of data, which would otherwise limit the useful life of the memory structure itself. Furthermore, due to the somewhat limited nature of flash memory (i.e., requiring an entire storage block of data to be erased and written over anew), such methodology aids in reducing the time required by the metering system to properly record each newly measured or calculated piece of data.

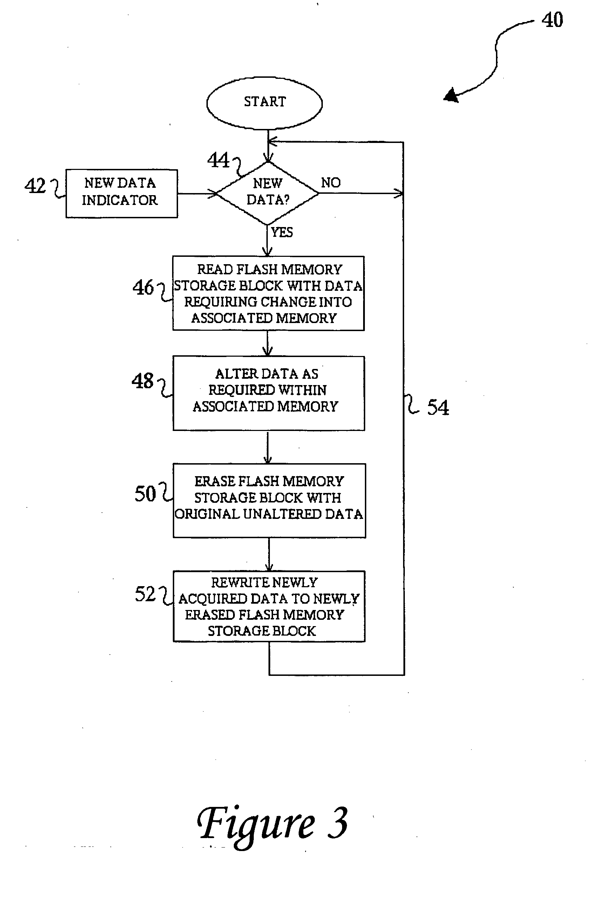

In accordance with another aspect of the present subject matter, Figure 3 displays a flow chart representative of an exemplary process 40 in which a memory structure associated with flash memory in a utility meter is used for the temporary storage and updating of recorded metering data. In the presently preferred embodiment, metering data is permanently stored in a multi-segmented non-volatile flash memory structure. An associated memory structure comprised of, for example and without limitation, EPROM, EEPROM, Ferro RAM, Shadow RAM, battery-backed RAM or other similar memory structure is also provided. Each of the non-volatile flash memory structure's segments contains measured and recorded metering data from a typical residential or commercial use solid-state utility meter. It should be noted that details of such meters form no particular aspect of the present technology and are well known to those of ordinary skill in the art. As such, the meter itself will not be discussed herein.

Upon the acquisition of newly measured or calculated data, such as but not limited to event/error/history logs, load profiles, time-of-use data, self-reads, etc., there exists a need to update the stored information. In accordance with the present subject matter, the detection of this new data may be done in a variety of fashions and is indicated in Figure 3 as new data indicator 42. One example of how new data could be indicated is to compare newly acquired data to that already stored in non-volatile memory to determine if the data requires updating. The present subject matter employs a process such as exemplary data preservation and storage method 40 to update newly acquired meter data. Such methodology works to reduce the number of times the non-volatile flash memory must be erased and rewritten thus lengthening its effective lifespan within the meter.

There could be other specific applications that require alteration or other changing of data, such as in accordance with performing meter upgrades, that aspects of the present subject matter, especially with respect to Figure 3, may be utilized.

Continuing with the exemplary process 40 of Figure 3, a determination of whether stored data needs updating is effected in step 44. Upon determining in step 44 that new data is indeed at hand, the storage block containing the old data is read from the non-volatile flash memory structure and copied into an associated memory structure in step 46.

Recent advances in flash memory have provided for small erase-block flash memory structures. This means that the amount of data read into an associated memory structure in step 46 is much smaller than might previously have been possible. Such advances in flash memory technology make the use of flash memory in metering applications more feasible since exemplary metering systems require about 256K of non-volatile memory and about 2K of supplemental memory. Thus, the amount of data read into an associated memory structure in step 46 has a minimum and maximum limit based on specific memory constraints. The minimum amount of data read from flash memory is equal to the smallest block size in flash memory. Existing flash memory may be characterized by about a thousand blocks or more per data array. The maximum amount of data read from flash memory in step 46 is determined by the storage limit of the associated memory structure.

The associated memory structure may be one that allows for the changing (e.g., updating) of data without the need for eliminating all of the data and replacing it with the newly acquired metering data as is the case with flash memory. Instead, only individual bits of information as needed within the entire storage block can be changed in such memory structure thus reducing the time required for updating the data. Thus, a selected block or blocks of data is read into the associated memory in step 46, at which point data can be altered within the associated memory in step 48.

On the completion of the alterations (such as updating) of the previously stored data in the associated memory structure in step 48, the non-volatile flash memory segment previously containing the unaltered data may be fully erased in step 50. The now updated data may then be rewritten into the newly erased storage block of the non-volatile flash memory in step 52. In accordance with the presently disclosed technology, the method then feeds back at path 54 to repeat itself so as to continuously offer the most up-to-date metering data.

While details thereof form no particular aspect of the present subject matter, the non-volatile flash memory structures may be provided to contain enough data to represent a utility-provider-defined time period such as one month. In such an instance, appropriate field personnel may "read" the meter to obtain the data either through direct viewing or by remote transmission/reception of the data at regular intervals so as to avoid the loss of any of the metering data.

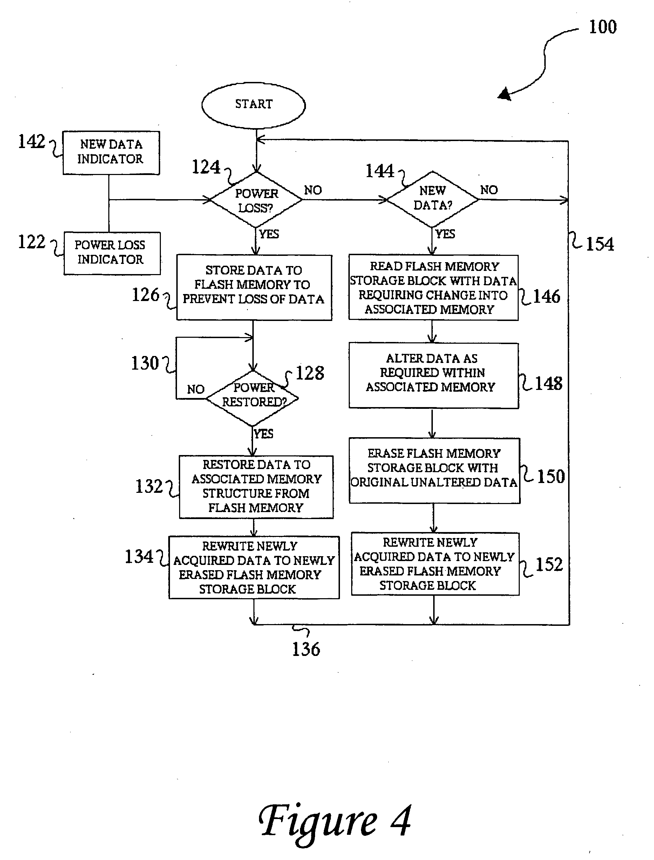

Figure 4 represents a flow chart diagram of an exemplary embodiment in which both data preservation and storage methodologies are provided, wherein such methodologies includes a data protection scheme for periods during which power to the meter is lost. Such methodology 100 preferably includes both means 142 for detecting newly acquired data and means 122 for determining an impending power loss 122. Means 142 may be implemented in a similar fashion to new data indicator means 42 and means 122 may be implemented in a similar fashion to power loss indication means 22, and details of either of such form no particular aspect of the present technology, and are otherwise within the knowledge of one of ordinary skill in the art.

In an effort to avoid the loss of any previously acquired meter data in the event of a power failure, a first step in exemplary method 100 corresponds to checking for such a power loss with detection means 122. If a power loss is detected at step 124, then there exists a need to transfer the metering data to a nonvolatile memory structure. Upon a funding that such a need exists, all metering data within the associated memory structure used for temporary storage and updating or other changing of data may be transferred to the nonvolatile flash memory structure in step 126.

Exemplary methodology 100 then begins a continuous check via step 128 and path 130 to determine if power has been restored to the solid-state meter. Such a determination may be made through any of the known methods and as it forms no particularly critical aspect of the present subject matter, such methods will not be further explained herein. Upon a detection in step 128 of the restoration of power to the meter, all of the data located within the non-volatile flash memory structure may be rewritten to the associated memory in step 132. The appropriate location in flash memory should then be erased in step 134 such that new data can be stored there again upon another power failure.

During its interrogation of the power loss detection means 122, should there exist no impending power loss, the methodology of the present technology next interrogates the newly acquired data detection means 142 in step 144. Such detection may operate to either automatically update the non-volatile flash memory upon each measurement or, more preferably, there may exist within means 142 further means for comparing the newly acquired data to that already stored in the non-volatile memory to determine if the data requires alteration. The later method works to reduce the number of times the non-volatile flash memory must be erased and rewritten, thus lengthening its effective lifespan within the meter.

When it is determined in step 144 that the stored data requires updating, the storage block containing the old data is read from the non-volatile flash memory structure and copied into the associated memory structure in step 146. The determination of the appropriate storage block of memory may be based on the use of a ring flash memory such that each successive set of newly acquired data belongs in the next successive segment of the ring memory, or other non-successive segment schemes may be alternatively practiced, per the present technology.

Desired alterations (e.g., updates) to the data previously stored in the associated memory structure are then performed in step 148. After this alteration is performed, the non-volatile flash memory segment previously containing the old data may be fully erased in step 150. The now updated data may then be rewritten into the newly erased storage block of the non-volatile flash memory in step 152. In accordance with the present technology, the methodologies then repeat themselves at paths 136 and 154 so as to continuously obtain the most up-to-date metering data while ensuring the protection of the already acquired metering data.

Although preferred embodiments of the disclosed technology have been described using specific terms and steps, such description is for illustrative purposes only. The words used are words of description rather than of limitation. It is to be understood that changes and variations may be made by those of ordinary skill in the art without departing from the scope of the present subject matter, which is set forth in the following claims. In addition, it should be understood that aspects of various other embodiments may be interchanged both in whole or in part. Therefore, the scope of the appended claims should not be limited to the description of the preferred version contained herein.

## Claims

1. A method for storing meter data, comprising the steps of:
providing a plurality of memory structures including at least one associated memory buffer (2) having a first predetermined storage size and a non-volatile flash memory structure (4) having a plurality of flash memory blocks (8) each having a second predetermined storage size;
obtaining meter data representative of one or more parameters associated with a utility product or service;
storing said meter data in the at least one associated memory buffer (2);
**characterized by**
detecting when said at least one associated memory buffer (2) is full; and
copying the data in said at least one associated memory buffer (2) into at least one selected flash memory block (8) of said non-volatile flash memory structure (4), in response to detecting that said buffer is full.

2. The method of claim 1, further comprising the step after said copying step of erasing the at least one associated memory buffer (2) such that it is configured to store additional meter data.

3. The method of claim 2, further comprising the step of continuously repeating said obtaining, storing, detecting, copying, and erasing steps.

4. The method of claim 1, wherein the at least one selected flash memory block (8) to which data is transferred in said copying step is determined via a flash pointer (10) that indicates the flash memory block (8) to which to begin copying data.

5. The method of claim 4, further comprising the steps after said copying step of:
erasing the at least one associated memory buffer (2) such that it is configured to store additional meter data; and
moving said flash pointer (10) to indicate the next flash memory block (8) location to where data should be copied.

6. The method of claim 5, further comprising the step of continuously repeating said obtaining, storing, detecting, copying, erasing and moving steps.

7. The method of claim 1, wherein said plurality of memory structures (2, 4) comprises a plurality of associated memory buffers (2) each configured to respectively follow said obtaining, storing, detecting and copying steps.

8. The method of claim 7, wherein the at least one selected flash memory block (8) to which data is transferred in said respective steps of copying meter data from each of said plurality of associated memory buffers (2) is determined via respective flash pointers (10) that indicate to which flash memory block (8) to begin copying data.

9. The method of claim 1, wherein said first and second predetermined storage sizes are substantially equal.

10. The method of claim 1, wherein said non-volatile flash memory structure (4) comprises at least thirty-two distinct flash memory blocks (8).

11. The method of claim 1, wherein said at least one associated memory buffer (2) comprises one of EPROM. EEPROM, RAM, Shadow RAM, Ferro RAM, and battery-backed RAM.

12. The method of claim 1, wherein said meter data comprises at least one of history logs, event logs, error logs, load profile data, time-of-use data, self reads, and energy consumption data.

13. The method of claim 1, further comprising the following steps:
determining if new data from the utility product or service are at hand;
copying the old data stored in at least one selected block (8) of said flash memory structure (4) into said at least one associated memory buffer (2);
updating the old data within said at least one associated memory buffer (2) with the corresponding new data;
fully erasing the at least one selected block of (8) said flash memory structure (4), from which data was transferred in said copying step; and
rewriting the updated selected data from said at least one associated memory buffer (2) to said at least one selected block (8) of said flash memory structure (4).

## Patentansprüche

1. Verfahren zum Speichern von Zählerdaten, umfassend folgende Schritte:
Vorsehen einer Vielzahl von Speicherstrukturen, die mindestens einen assoziierten Speicherpuffer (2) mit einer ersten vorgegebenen Speichergröße und eine nichtflüchtige Flash-Speicherstruktur (4) mit einer Vielzahl von Flash-Speicher-Blöcken (8) mit jeweils einer zweiten vorgegebenen Speichergröße enthalten;
Empfangen von Zählerdaten, die repräsentativ für einen oder mehrere Parameter sind, die mit einem Versorgungsprodukt oder einer Versorgungsdienstleistung assoziiert sind;
Speichern der besagten Zählerdaten in dem mindestens einen assoziierten Speicherpuffer (2);
**gekennzeichnet durch**
Erkennen, wenn der mindestens eine assoziierte Speicherpuffer (2) voll ist; und
Kopieren der Daten in dem besagten mindestens einen zugehörigen Speicherpuffer (2) in mindestens einen ausgewählten Flash-Speicher-Block (8) der besagten nichtflüchtigen Flash-Speicherstruktur (4) als Reaktion auf das Erkennen, dass der besagte Puffer voll ist.

2. Verfahren nach Anspruch 1, weiter umfassend nach dem besagten Kopierschritt den Schritt des Löschens des mindestens einen assoziierten Speicherpuffers (2), sodass er eingerichtet ist, zusätzliche Zählerdaten zu speichern.

3. Verfahren nach Anspruch 2, weiter umfassend den Schritt fortlaufenden Wiederholens der besagten Empfangs-, Speicher-, Erkennungs-, Kopier- und Lösch-Schritte.

4. Verfahren nach Anspruch 1, wobei der mindestens eine ausgewählte Flash-Speicher-Block (8), in den Daten in dem besagten Kopierschritt übertragen werden, über einen Flash-Zeiger (10) bestimmt ist, der den Flash-Speicher-Block (8) anzeigt, in dem das Kopieren der Daten beginnen soll.

5. Verfahren nach Anspruch 4, weiter umfassend folgende Schritte nach dem besagten Kopierschritt:
Löschen des mindestens einen assoziierten Speicherpuffers (2), sodass er konfiguriert ist, zusätzliche Zählerdaten zu speichern; und
Bewegen des besagten Flash-Zeigers (10), um die nächste Stelle des Flash-Speicher-Blocks (8) anzuzeigen, an die Daten kopiert werden sollten.

6. Verfahren nach Anspruch 5, weiter umfassend den Schritt des fortlaufenden Wiederholens der besagten Empfangs-, Speicher-, Erkennungs-, Kopier-, Lösch- und Bewegungs-Schritte.

7. Verfahren nach Anspruch 1, wobei die besagte Vielzahl von Speicherstrukturen (2, 4) eine Vielzahl assoziierte Speicherpuffer (2) umfasst, die jeweils konfiguriert sind, den besagten Empfangs-, Speicher-, Erkennungs- und Kopier-Schritten zu folgen.

8. Verfahren nach Anspruch 7, wobei der mindestens eine ausgewählte Flash-Speicher-Block (8), in den Daten in den besagten jeweiligen Schritten des Kopierens von Zählerdaten aus jedem der besagten Vielzahl von assoziierten Speicherpuffer (2) übertragen werden. über jeweilige Flash-Zeiger (10) bestimmt ist, die anzeigen, in welchem Flash-Speicher-Block (8) das Kopieren der Daten beginnen soll.

9. Verfahren nach Anspruch 1, wobei die besagte erste und die besagte zweite vorgegebene Speichergröße im Wesentlichen gleich sind.

10. Verfahren nach Anspruch 1, wobei die besagte nichtflüchtige Flash-Speicherstruktur (4) mindestens zweiunddreißig verschiedene Flash-Speicher-Blöcke (8) umfasst.

11. Verfahren nach Anspruch 1, wobei der besagte mindestens eine assoziierte Speicherpuffer (2) einen aus EPROM, EEPROM, RAM, Shadow-RAM, Ferro-RAM und batteriegepuffertem RAM umfasst.

12. Verfahren nach Anspruch 1, wobei die besagten Zählerdaten mindestens eins aus Verlaufsprotokollen, Ereignisprotokollen, Fehlerprotokollen, Lastprofildaten, Nutzungszeitdaten, Selbstablesungen und Energieverbrauchsdaten umfassen.

13. Verfahren nach Anspruch 1, weiter umfassend die folgenden Schritte:
Bestimmen, ob neue Daten über das Versorgungsprodukt oder die Versorgungsdienstleistung zur Verfügung stehen;
Kopieren der alten Daten, die in mindestens einem ausgewählten Block (8) der besagten Flash-Speicherstruktur (4) gespeichert sind, in den besagten mindestens einen assoziierten Speicherpuffer (2);
Aktualisieren der alten Daten in dem besagten mindestens einen assoziierten Speicherpuffer (2) durch die entsprechenden neuen Daten;
vollständiges Löschen des mindestens einen ausgewählten Blocks (8) der besagten Flash-Speicherstruktur (4), aus der Daten in dem besagten Kopierschritt übertragen wurden; und
Neuschreiben der aktualisierten ausgewählten Daten aus dem besagten mindestens einen assoziierten Speicherpuffer (2) in den besagten mindestens einen ausgewählten Block (8) der besagten Flash-Speicherstruktur (4).

## Revendications

1. Méthode pour stocker des données de compteur, comprenant les étapes suivantes:
fournir une multitude de structures de mémoire comprenant au moins une mémoire tampon associée (2) possédant une première capacité de mémoire prédéterminée et une structure de mémoire flash non-volatile (4) possédant une multitude de blocs de mémoire flash (8) présentant chacun une seconde capacité de mémoire prédéterminée;
acquérir des données de compteur représentatives d'un ou de plusieurs paramètres associés à un produit ou un service d'utilité publique;
stocker lesdites données de compteur dans l'au moins une mémoire tampon associée (2);
**caractérisée par**
la détection de l'état plein de ladite au moins une mémoire tampon associée (2); et
le copiage des données dans ladite au moins une mémoire tampon (2) dans au moins un bloc de mémoire flash sélectionné (8) de ladite structure de mémoire flash non-volatile (4) en réponse à la détection de l'état plein dudit tampon.

2. Méthode selon la revendication 1, comprenant en outre, après ladite étape de copiage, l'étape consistant à effacer l'au moins une mémoire tampon associée (2) de sorte qu'elle soit configurée pour stocker des données de compteur supplémentaires.

3. Méthode selon la revendication 2, comprenant en outre l'étape consistant à répéter continuellement lesdites étapes d'acquisition, de stockage, de détection, de copiage et d'effacement.

4. Méthode selon la revendication 1, dans laquelle l'au moins un bloc de mémoire flash sélectionné (8), vers lequel les données sont transférées dans ladite étape de copiage, est déterminé via un pointeur flash (10), qui indique le bloc de mémoire flash (8) vers lequel doit commencer le copiage des données.

5. Méthode selon la revendication 4, comprenant en outre les étapes suivantes après ladite étape de copiage:
effacer l'au moins une mémoire tampon associée (2) de sorte qu'elle soit configurée pour stocker des données de compteur supplémentaires; et
déplacer ledit pointeur flash (10) pour qu'il indique le prochain emplacement de bloc de mémoire flash (8) vers lequel les données doivent être copiées.

6. Méthode selon la revendication 5, comprenant en outre l'étape consistant à répéter continuellement lesdites étapes d'acquisition, de stockage, de détection, de copiage, d'effacement et de déplacement.

7. Méthode selon la revendication 1, dans laquelle ladite multitude de structures de mémoire (2, 4) comprend une multitude de mémoires tampons associées (2) configurées chacune pour suivre respectivement lesdites étapes d'acquisition, de stockage, de détection et de copiage.

8. Méthode selon la revendication 7, dans laquelle l'au moins un bloc de mémoire flash sélectionné (8), vers lequel les données sont transférées dans lesdites étapes respectives de copiage des données de compteur depuis chacune desdites mémoires tampons associées (2) de ladite multitude de mémoires tampons associées (2), est déterminé via des pointeurs flash respectifs (10), qui indiquent vers quel bloc de mémoire flash (8) le copiage des données doit commencer.

9. Méthode selon la revendication 1, dans laquelle lesdites première et seconde capacités de mémoire prédéterminées sont substantiellement égales.

10. Méthode selon la revendication 1, dans laquelle ladite structure de mémoire flash non-volatile (4) comprend au moins trente-deux blocs de mémoire tampon distincts (8).

11. Méthode selon la revendication 1, dans laquelle ladite au moins une mémoire tampon associée (2) comprend soit un EPROM, soit un EEPROM, soit une mémoire RAM, soit une mémoire Shadow RAM, soit une mémoire Ferro-RAM, soit une mémoire RAM sauvegardée par batterie.

12. Méthode selon la revendication 1, dans laquelle lesdites données de compteur comprennent au moins soit des journaux d'historique, soit des journaux d'évènements, soit des journaux d'erreurs, soit des données de profil de charge, soit des données de temps d'utilisation, soit des données d'auto-lecture, soit des données de consommation d'énergie.

13. Méthode selon la revendication 1, comprenant en outre les étapes suivantes:
déterminer si de nouvelles données sont disponibles depuis le produit ou service d'utilité publique;
copier les anciennes données stockées dans au moins un bloc sélectionné (8) de ladite structure de mémoire flash (4) dans ladite au moins une mémoire tampon associée (2);
mettre à jour les anciennes données au sein de ladite au moins une mémoire tampon associée (2) avec les nouvelles données correspondantes;
effacer totalement l'au moins un bloc sélectionné (8) de ladite structure de mémoire flash (4) depuis lequel les données ont été transférées dans ladite étape de copiage; et
réécrire les données sélectionnées mises à jour depuis ladite au moins une mémoire tampon associée (2) vers ledit au moins un bloc sélectionné (8) de ladite structure de mémoire flash (4).
